(19) Europäisches Patentamt
European Patent Office
Office européen des brevets

(11) **EP 2 256 836 B1**

(12) **EUROPÄISCHE PATENTSCHRIFT**

(45) Veröffentlichungstag und Bekanntmachung des Hinweises auf die Patenterteilung:
**10.10.2012 Patentblatt 2012/41**

(51) Int Cl.:
*H01L 41/047* (2006.01)    *H01L 41/083* (2006.01)
*H01L 41/22* (2006.01)

(21) Anmeldenummer: **10179362.8**

(22) Anmeldetag: **05.08.2005**

(54) **Verfahren zur Herstellung eines Vielschichtbauelementes**

Method for fabrication of a multilayer element

Procédé de fabrication d'un élément multicouche

(84) Benannte Vertragsstaaten:
**DE**

(30) Priorität: **05.08.2004 DE 102004038103**

(43) Veröffentlichungstag der Anmeldung:
**01.12.2010 Patentblatt 2010/48**

(62) Dokumentnummer(n) der früheren Anmeldung(en) nach Art. 76 EPÜ:
**05774389.0 / 1 774 603**

(73) Patentinhaber: **EPCOS AG**
**81669 München (DE)**

(72) Erfinder:
• **Riemer, Steffen**
**8564 Krottendorf (AT)**
• **Ragossnig, Sigrid**
**9313 St. Georgen am Längsee (AT)**
• **Sedlmayer, Peter**
**9113 Ruden (AT)**
• **Florian, Heinz**
**8524 Bad Gams (AT)**

(74) Vertreter: **Epping - Hermann - Fischer**
**Patentanwaltsgesellschaft mbH**
**Ridlerstrasse 55**
**80339 München (DE)**

(56) Entgegenhaltungen:
**EP-A1- 1 732 146      DE-A1- 3 832 658**
**DE-A1- 19 946 836**

• **PATENT ABSTRACTS OF JAPAN Bd. 012, Nr. 402 (E-673), 25. Oktober 1988 (1988-10-25) -& JP 63, 142875, A, (SUMITOMO SPECIAL METALS CO LTD), 15. Juni 1988 (1988-06-15)**
• **PATENT ABSTRACTS OF JAPAN Bd. 2002, Nr. 07, 3. Juli 2002 (2002-07-03) -& JP 2002, 075774, A, (FURUYA KINZOKU:KK), 15. März 2002 (2002-03-15)**
• **PATENT ABSTRACTS OF JAPAN Bd. 016, Nr. 417 (E-1258), 3. September 1992 (1992-09-03) -& JP 04, 142085, A, (HITACHI METALS LTD), 15. Mai 1992 (1992-05-15)**
• **PATENT ABSTRACTS OF JAPAN Bd. 1996, Nr. 06, 28. Juni 1996 (1996-06-28) -& JP 08, 055753, A, (TAIYO YUDEN CO LTD), 27. Februar 1996 (1996-02-27)**
• **PATENT ABSTRACTS OF JAPAN Bd. 2002, Nr. 11, 6. November 2002 (2002-11-06) -& JP 2002, 208533, A, (MATSUSHITA ELECTRIC IND CO LTD), 26. Juli 2002 (2002-07-26)**
• **PATENT ABSTRACTS OF JAPAN Bd. 2002, Nr. 11, 6. November 2002 (2002-11-06) -& JP 2002, 198250, A, (KYOCERA CORP), 12. Juli 2002 (2002-07-12)**
• **PATENT ABSTRACTS OF JAPAN Bd. 015, Nr. 195 (E-1069), 20. Mai 1991 (1991-05-20) -& JP 03, 052211, A, (MATSUSHITA ELECTRIC IND CO LTD), 6. März 1991 (1991-03-06)**

**Beschreibung**

Die vorliegende Erfindung betrifft ein Verfahren zur Herstellung eines Vielschichtbauelements.

Eine Schlüsselrolle für die Applikation von Vielschichtbauelementen umfassend piezo- und ferroelektrische Aktoren spielt die mechanische Eigensteifigkeit des Bauelements.

Aus der WO 99/12865 sind piezokeramische Materialien auf der Basis von Bleizirkonat-Titanat bekannt. Dabei wird beim Bleizirkonat-Titanat mit einer Perowskitstruktur $A^{2+}B^{4+}O_3$ durch partielle Substitution mit ferroelektrisch aktiven Verbindungen eine angestrebte Stabilisierung der Werkstoffe erreicht und gleichzeitig die Verringerung der Sintertemperatur ermöglicht.

Eine zu lösende Aufgabe besteht darin, ein Herstellungsverfahren für ein Vielschichtbauelement anzugeben, welches bei möglichst geringer Spannung einen hohen Auslenkungsweg erreicht.

Die Aufgabe wird hinsichtlich der Herstellung eines Vielschichtbauelements durch die Merkmale des unabhängigen Anspruchs gelöst.

Es wird ein Verfahren zur Herstellung eines Vielschichtbauelements vorgeschlagen, welches folgende Merkmale umfasst: einen keramischen Grundkörper und mindestens eine im keramischen Grundkörper angeordnete Innenelektrode, wobei die Innenelektrode mehrere Löcher aufweist.

Ein solches Vielschichtbauelement hat den Vorteil, dass die Steifigkeit der Innenelektrode entgegen einer queraxialen Kontraktion teilweise oder ganz verringert wird und dadurch während einer axialen Auslenkung des Vielschichtbauelements eine quasi störungsfreie queraxiale Querkontraktion der Innenelektrode möglich ist. Mit der Querkontraktion wird gleichzeitig bei gleicher angelegter Spannung ein höherer axialer Auslenkungsweg des Vielschichtbauelements erreicht.

Das Vielschichtbauelement kann vorteilhafterweise dichter gesintert werden, da eine mit mehreren Löchern versehene Innenelektrode einen geringeren mechanischen Widerstand gegenüber der Keramik des Grundkörpers stellt, welche während des Sinterns stets zu schrumpfen bestrebt ist. Eine höhere Sinterdichte wird von verbesserten elektrischen Eigenschaften begleitet, und ist somit von Vorteil. Eine höhere Sinterdichte ermöglicht außerdem auch einen höheren Auslenkungsweg. Bei einem Piezoktor kann dies je nach Anwendung von besonderem Vorteil sein.

Ein derartiges Vielschichtbanelement sowie Herstellungsverfahren dafür sind aus der JP 63 - 142 875 und DE 3832658 bekannt.

Zur Herstellung eines Vielschichtbauelements wird vorgeschlagen, dass keramische Folien bereitgestellt werden, auf die Innenelektrodenmaterial, vorzugsweise in der Form einer Paste, gedruckt wird. Die Folien werden gestapelt, geschnitten oder erst geschnitten und dann gestapelt. Das so erhaltene Vielschichtbauelement wird anschließend gesintert.

Als Innenelektrodenmaterial wird Kupfer oder eine Kupferlegierung verwendet. Das Material wird in der Form einer Paste mittels Siebdrucken auf die keramische Folien gebracht, wobei ein Sieb verwendet wird, das vorzugsweise zu einem Bedruckungsmuster der Innenelektrode führt, das Löcher bzw. Unterbrechungen mit Durchmessern zwischen 10 und 20 $\mu$m aufweist. Nach dem Stapeln der Folien wird das dadurch erhaltene Bauelement bei einer Temperatur zwischen 1000°C und 1100°C, vorzugsweise bei 1050°C, gesintert.

Im Folgenden wird ein Vielschichtbauelement anhand bevorzugter Ausführungsbeispiele näher erläutert. Dabei zeigt

Figur 1      einen Vielschichtpiezoaktor mit einer Piezokeramikschicht welche an eine mit Löchern versehenen Innenelektrode angrenzt,

Figur 2      eine vergrößerte Darstellung der mit Löchern versehenen Elektrode,

Figur 3      eine zweidimensionale fotographische Abbildung einer mit Löchern versehenen Innenelektrode,

Figur 4      eine Graphik zur Darstellung einer bevorzugten, optimalen Einstellung eines durch die Löcher erzeugten Unterbrechungsgrades der Innenelektrode, einer auf den Vielschichtpiezoaktor anzulegenden Spannung und eines Auslenkungswegs des Vielschichtpiezoaktors.

Es wird ein Weg aufgezeigt, wie bei gegebener Bauteilgeometrie und vorgegebenem Keramik- und Innenelektrodenmaterial die Steifigkeit des Vielschichtbauelements aktiv variiert werden kann.

Es wurde für Testzwecke, beispielsweise auf einem Kraft- oder Auslenkungsmeßplatz, die Steifigkeit von Vielschichtaktoren gemessen. Der sich aus der Messung ergebende integrale Bauteilsteifigkeitswert wurde dabei eins zu eins der Elastizität der Keramik zugeschrieben. In anderen Worten: ein höherer Steifigkeitswert indizierte eine härtere Keramik, je nachdem, ob die Keramik donatordotiert oder akzeptordotiert wurde. Aus dieser Überlegung heraus wurde vor allem über die Zusammensetzung der Keramik (Keramikrezeptur) versucht, den E-Modul des Vielschichtpiezoaktors und somit die Bauteilsteifigkeit einzustellen.

Allgemein kann aber die Steifigkeit K eines Vielschichtbauelements in einem ersten Schritt über die Formel

$$K = \frac{Y \cdot A}{l}$$

abgeschätzt werden, wobei Y das E-Modul, A die Querschnittsfläche und 1 die Länge des Vielschichtbauelements oder des aktiven Grundkörpers des Vielschichtbauelements ist.

Im Folgenden wird angenommen, dass das Vielschichtbauelement einen Vielschichtpiezoaktor umfasst, wobei andere Vielschichtbauelemente ebenfalls möglich sind, wie beispielsweise Vielschichtkondensatoren oder andere Keramikumfassende Vielschichtbauelemente.

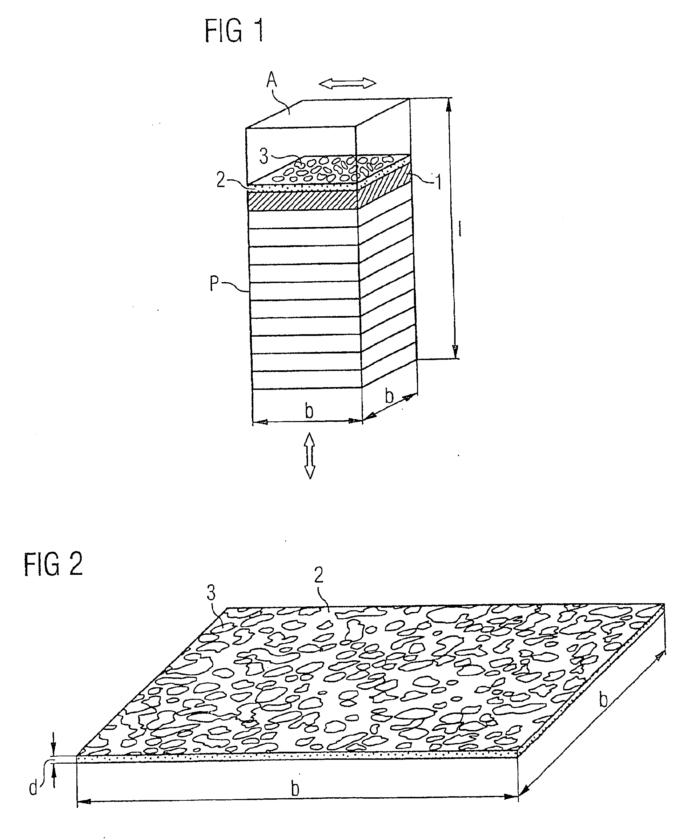

Die Eigensteifigkeit des in Figur 1 gezeigten Vielschichtpiezoaktors P ist direkt proportional zum E-Modul Y und zur Querschnittsfläche A des Vielschichtpiezoaktors P, jedoch indirekt proportional zur Länge 1 des Vielschichtpiezoaktors ist. Die Querschnittsfläche A und die Länge I sind durch die jeweilige Applikation vorgegeben und somit durch das Anwendungsdesign des Vielschichtpiezoaktors fixiert. Es bleibt daher nur die Variation des E-Moduls Y, um die Bauteilsteifigkeit einzustellen. Dabei handelt es sich um einen integralen E-Modul, welches von dem keramischen Grundkörper bzw. der Anordnung von aufgestapelten Keramikschichten 1 und von der mindestens einen Innenelektrode 2 sowie vom Innenelektrodenverbund mehrerer Innenelektroden 2 abhängig ist. So wird der integrale Bauteil E-Modul Y einerseits durch das Keramikmaterial selbst und andererseits durch das Material und die Geometrie der Innenelektrode 2 bestimmt.

Es ist eine Eigenschaft piezo/ferroelektrischer Materialien, sich bei anliegender elektrischer Spannung auszulenken. Mit der Auslenkung in eine Raumrichtung, beispielsweise die axiale Richtung (unterer Pfeil), geht eine queraxiale Kontraktion (oberer Pfeil) oder Querkontraktion in den Raumrichtungen normal auf die Auslenkungsrichtung einher. Bei Vielschichtpiezoaktoren mit durchgehenden Innenelektroden stehen dieser Querkontraktion die Innenelektroden als mechanischer Gegenspieler entgegen und reduzieren dadurch im Vergleich zu einem monolithischen Keramikquader ohne Innenelektroden die Querkontraktion und damit auch die Auslenkung des Bauteils.

Um also die Querkontraktion zu erleichtern werden erfindungsgemäß die Innenelektroden 2 mit Löchern versehen, wobei es aber nicht erforderlich ist, dass die Löcher die Innenelektrode ganz durchbohren- vorzugsweise können sie auch als erhebliche Einbuchtungen realisiert sein.

Über die beiden Parameter Dicke d der Innenelektroden 2 und des Unterbrechungsgrades 3D, das heißt die Anzahl der Löcher 3 in der Innenelektrode pro Flächeneinheit der Innenelektrode, lassen sich der integrale E-Modul des Vielschichtpiezoaktors und somit seine Steifigkeit bei einer gegebenen Geometrie variieren. Im Profilschliff zeigt sich der Unterbrechungsgrad 3D als elektrodenmaterialfreie Bereiche innerhalb der Innenelektrode. Zur Anpassung der Bauteilsteifigkeit sind also zwei Parameter vorgesehen: die Dicke d der Innenelektrode 2 und der Unterbrechungsgrad 3D der Innenelektrode.

Dabei wird bevorzugt, dass die Dicke der Innenelektroden so gering wie möglich gehalten wird, da hiermit einerseits geringere Mengen an Elektrodenmaterial verwendet werden müssen und somit geringere Kosten anfallen, und andererseits eine höhere Sinterdichte des Vielschichtbauelements erreicht werden kann. Der Vielschichtpiezoaktor ist vorzugsweise so ausgebildet, dass die Innenelektroden mit einer elektrisch leitenden Kontaktschicht verbunden sind um die elektrische Verbindung an eine Spannungs- und Stromquelle herzustellen.

Figur 2 veranschaulicht die Struktur einer erfindungsgemäßen Innenelektrode 2. Die weißen Kreise stellen die Löcher 3 dar. Der Unterbrechungsgrad 3D kann folgendermaßen als Formel ausgedrückt werden:

$$3D = \frac{\sum_{i=1}^{N} AL_i[m^2]}{b^2[m^2]}$$

wobei AL die Fläche eines Lochs oder vorzugsweise die durchschnittliche Fläche eines Lochs (in Quadratmeter), N die Anzahl der Löcher und b die Länge einer Seite der Innenelektrode ist. Der Unterbrechungsgrad wird in Prozent angegeben.

Zur Herstellung eines elektrischen Bauelements mit einer mit Löchern versehenen Innenelektrode 2 werden Folien bereitgestellt, die keramisches Material mit piezoelektrischen Eigenschaften, beispielsweise Bleizirkonat-Titanat, enthalten. Es ist jedoch auch piezoelektrisch aktives keramisches Material einsetzbar, das eine andere Zusammensetzung aufweist, wie zum Beispiel eine Mischung aus Bleizirkonat-Titanat und Blei-Nickelniobat sowie ein Material, das kein Blei enthält, wie zum Beispiel Natrium-Kaliumniobat.

Gemäß der Erfindung enthält eine zum Siebdrucken auf die Keramikfolien bereitgestellte Paste Kupfer oder eine Kupferlegierung. Das Sieb ist derart mit einem Film beschichtet, dass ein Bedruckungsmuster entsteht, bei dem die Kupferschicht mit kreisförmigen Unterbrechungen bzw. Löchern mit jeweils etwa 10 bis 20 μm Durchmesser versehen wird.

Die mit der Kupfer- oder der Kupferlegierungspaste bedruckten Folien werden in der Weise gestapelt und miteinander verpresst, dass ein der Funktion des elektrischen Bauelements entsprechender Stapel entsteht.

Das Bauelement, das Kupfer oder die Kupferlegierung als Innenelektrode enthält, wird nach dem Ausbrand des organischen Bindemittels auf 1050°C erwärmt und bei dieser Temperatur zwei Stunden lang gehalten und währenddessen gesintert. Die netzförmige Struktur der Kupferelektrode erfolgt durch die Art der Bedruckung mit einem geeigneten Sieb.

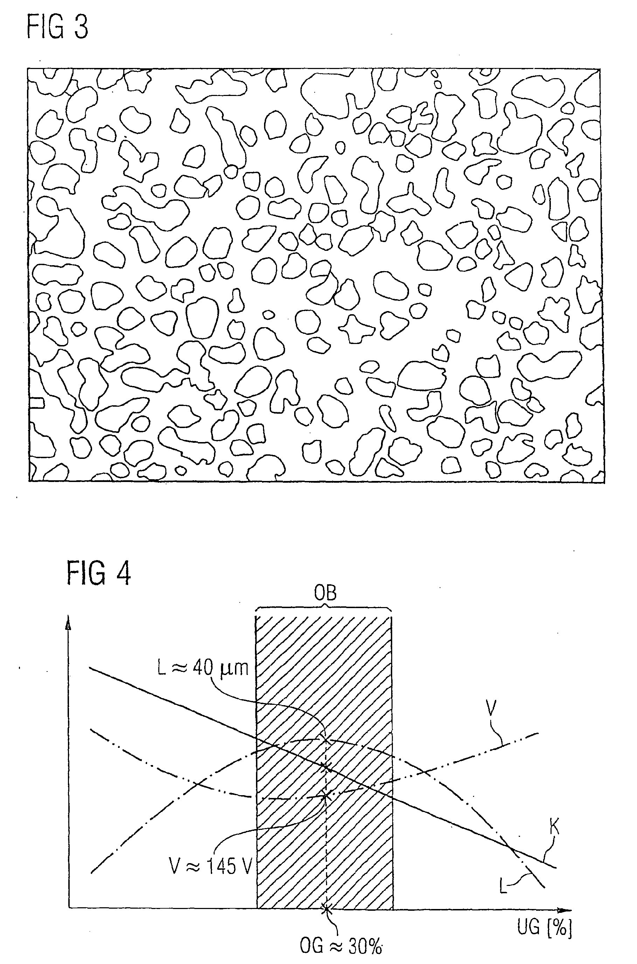

Figur 3 zeigt ein REM-Bild einer durch die thermische Prozessführung netzförmig ausgebildete Innenelektrode.

Die beim Sintern zu erwartende Anzahl der Löcher 3 und deren aufsummierte Fläche kann durch Erfahrungswerte aus Testergebnissen ermittelt werden, wobei die Bildung der Löcher von der Temperatur und dem Druck beim Sintern sowie vom Material der Innenelektrode beeinflusst wird.

Figur 4 zeigt qualitativ eine Kurve K, welche die Änderung der Steifigkeit der Innenelektrode in Abhängigkeit des Unterbrechungsgrades UG darstellt. Kurve V zeigt Spannungen, die auf den Vielschichtpiezoaktor angelegt werden, um einen bestimmten Auslenkungsweg L des Vielschichtpiezoaktors zu erreichen. Die Kurve L zeigt unterschiedliche Auslenkungswege, welche mit einer konstanten Spannung erreicht werden. Die Form der Kurven L und V ist zudem vom Unterbrechungsgrad der Innenelektrode bzw. von ihrer Steifigkeit K abhängig. Da die Kurven V, K und L alle unterschiedliche physikalische Größen betreffen, ist die linke Achse der Grafik ohne kennzeichnende Einheit angegeben. Es wird insbesondere bevorzugt, dass die Innenelektrode einen Unterbrechungsgrad innerhalb des in der Figur 4 angegebenen optimalen Bereichs OB aufweist, da hier der tiefste Punkt der Kurve V, also eine niedrige Spannung, den höchsten Punkt der Kurve L, also einen hohen Auslenkungsweg, entspricht. Es hat sich ergeben, dass ein Unterbrechungsgrad UG von ca. 30% (qualitativ auf der untersten horizontalen Achse mit einem x markiert) geeignet ist, um einen maximalen Auslenkungsweg von 40 $\mu$m des Vielschichtpiezoaktors bei einer minimalen Spannung von 145 V zu erreichen.

Es wird bevorzugt, dass die Durchmesser der kreisförmigen Löcher der Innenelektrode bei 10$\mu$m bis 15$\mu$m liegen und/oder die Flächen von nichtkreisförmigen Löchern bei ca. 50 bis 90 $\mu$m$^2$ liegen. Diese relativ geringen Größen verhindern, dass sich an den Löchern unerwünschte und störende elektrische Felder bilden. Mit dieser Maßnahme kann das elektrische Feld über der gesamten Innenelektrode als homogen betrachtet werden. Für derart kleine Löcher ist es daher vorteilhaft, die Löcher während des Sinterns nach dem erfindungsgemäßen Herstellungsverfahrens auszubilden, da per Siebdruckverfahren derart kleine Löcher schwer zu realisieren sind.

Die Sinterdichte des keramischen Grundkörpers, bzw. dessen Dielektrikums- oder Keramikschichten hängt mit der geometrischen Struktur der Innenelektrode zusammen. Sind die Innenelektroden durchgängig, stellen diese einen größeren Widerstand gegenüber dem Bestreben des keramischen Grundkörpers während des Sinterns zu schrumpfen entgegen. Mit Löchern versehene Innenelektroden erlauben in Gegensatz dazu die Herstellung von Vielschichtbauelementen mit tendenziell höheren Sinterdichten, da die Innenelektroden einen geringeren Widerstand gegenüber dem Schrumpfen des keramischen Grundkörpers entgegenstellen. Höhere Sinterdichten haben den Vorteil, dass ein größeres Kornwachstum begleitet von Poreneliminierung, bzw. Reduzierung freier Kornoberflächen des keramischen Materials ermöglicht wird, wobei im Allgemeinen eine Verringerung der Oberflächen- und Korngrenzenenergie angestrebt wird, die zu einer Erniedrigung der gesamten freien Enthalpie des Sinterkörpers führt. Die elektrischen Eigenschaften des gesinterten Vielschichtpiezoaktors werden somit verbessert, da beispielsweise eine homogenere elektromagnetische Feldverteilung und ein einfacheres und voraussehbares Auslenkungsverhalten des Vielschichtpiezoaktors gewährleistet wird. Eine höhere Sinterdichte ist daher auch nicht nur für Vielschichtpiezoaktoren, sondern beispielsweise auch für Vielschichtkondensatoren, von besonderem Interesse.

Bezugszeichenliste

1    keramische Schicht
2    Innenelektrode
3    Loch einer Innenelektrode

A    Querschnittsfläche eines Piezoaktors
l    Länge des Piezoaktors
b    Länge einer Seite einer Innenelektrode
P    Piezoaktor

**Patentansprüche**

1. Verfahren zur Herstellung eines Vielschichtbauelements (P) mit einer Innenelektrode (2) und einem keramischen Grundkörper, bei dem Innenelektrodenmaterial mittels Siebdrucken auf eine keramischen Folie (1) gebracht wird, wobei ein Sieb verwendet wird, welches eine mit Löchern (3) versehene Innenelektrode erzeugt, **dadurch gekennzeichnet, dass** als Innenelektrodenmaterial Kupfer oder eine Kupferlegierung verwendet wird und das Vielschichtbauelement (P) bei einer Temperatur zwischen 1000°C und 1100°C gesintert wird.

2. Verfahren nach Anspruch 1, bei dem die Löcher (3) Durchmesser zwischen 10 und 20 $\mu$m aufweisen.

3. Verfahren nach einem der Ansprüche 1 bis 2, bei dem als Vielschichtbauelement (P) ein Vielschichtpiezoaktor gebildet wird.

4. Verfahren nach einem der Ansprüche 1 bis 3, bei dem durch die Ausbildung der Löcher (3)die Steifigkeit der Innenelektrode (2) gegenüber einer queraxialen Kontraktion teilweise oder ganz verringert wird.

5. Verfahren nach einem der Ansprüche 1 bis 4, bei dem das Verhältnis der Fläche der Löcher (3) zur Fläche der Innenelektrode (2) bei 30 % liegt.

6. Verfahren nach einem der Ansprüche 1 bis 5, bei dem die Löcher (3) über die Querschnittsfläche (A) der Innenelektrode (2) verteilt sind.

## Claims

1. Method for producing a multilayer component (P) having an internal electrode (2) and a ceramic main body, in which method internal electrode material is applied to a ceramic film (1) by means of screen printing, use being made of a screen which produces an internal electrode provided with holes (3), **characterized in that** the internal electrode material used is copper or a copper alloy, and the multilayer component (P) is sintered at a temperature of between 1000°C and 1100°C.

2. Method according to Claim 1, wherein the holes (3) have diameters of between 10 and 20 $\mu$m.

3. Method according to either of Claims 1 and 2, wherein the multilayer component (P) is in the form of a multilayer piezoelectric actuator.

4. Method according to one of Claims 1 to 3, wherein the rigidity of the internal electrode (2) against trans-axial contraction is partially or completely reduced by the formation of the holes (3).

5. Method according to one of Claims 1 to 4, wherein the ratio between the surface area of the holes (3) and the surface area of the internal electrode (2) is 30%.

6. Method according to one of Claims 1 to 5, wherein the holes (3) are distributed over the cross-sectional area (A) of the internal electrode (2).

## Revendications

1. Procédé de fabrication d'un composant multicouche (P) comprenant une électrode interne (2) et un corps de base en céramique, selon lequel le matériau de l'électrode interne est appliqué par sérigraphie sur un film en céramique (1), un tamis étant utilisé, laquelle produit une électrode interne munie de trous (3), **caractérisé en ce que** le matériau d'électrode interne utilisé est du cuivre ou un alliage de cuivre et le composant multicouche (P) est fritté à une température comprise entre 1000 °C et 1100 °C.

2. Procédé selon la revendication 1, selon lequel les trous (3) présentent un diamètre compris entre 10

et 20 $\mu$m.

3. Procédé selon l'une des revendications 1 et 2, selon lequel le composant multicouche (P) formé est un actionneur piézoélectrique multicouche.

4. Procédé selon l'une des revendications 1 à 3, selon lequel, du fait de la formation des trous (3), la rigidité de l'électrode interne (2) à une contraction axiale transversale est partiellement ou totalement réduite.

5. Procédé selon l'une des revendications 1 à 4, selon lequel le rapport entre la surface des trous (3) et la surface de l'électrode interne (2) est de l'ordre de 30 %.

6. Procédé selon l'une des revendications 1 à 5, selon lequel les trous (3) sont distribués sur la surface transversale (A) de l'électrode interne (2).

FIG 1

FIG 2

## FIG 3

## FIG 4

L ≈ 40 μm

OB

V

K

V ≈ 145 V

L

UG [%]

OG ≈ 30%

**IN DER BESCHREIBUNG AUFGEFÜHRTE DOKUMENTE**

**In der Beschreibung aufgeführte Patentdokumente**

- WO 9912865 A
- JP 63142875 A
- DE 3832658